# EUROPÄISCHE PATENTSCHRIFT

(11) **EP 1 494 965 B1**
(45) Veröffentlichungstag und Bekanntmachung des Hinweises auf die Patenterteilung: **06.09.2017**
(21) Anmeldenummer: 03727305.9
(22) Anmeldetag: 15.04.2003
(51) Int. Cl.: B81C 1/00

(54) **VERFAHREN ZUR HERSTELLUNG EINES ERZEUGNISSES MIT EINER STRUKTURIERTEN OBERFLÄCHE**
METHOD FOR PRODUCING A PRODUCT HAVING A STRUCTURED SURFACE
PROCEDE DE PRODUCTION D'UN ARTICLE A SURFACE STRUCTUREE

(30) Priorität: 15.04.2002 DE 20205830 U; 23.05.2002 DE 10222958; 23.05.2002 DE 10222964; 23.05.2002 DE 10222609; 13.11.2002 DE 10252787; 16.01.2003 DE 10301559
(43) Veröffentlichungstag der Anmeldung: 12.01.2005
(73) Patentinhaber: Schott AG, 55122 Mainz (DE)
(72) Erfinder: BIECK, Florian, 13187 Berlin (DE); LEIB, Jürgen, 85354 Freising (DE); MUND, Dietrich, 84101 Obersüssbach (DE)
(74) Vertreter: Herden, Andreas F.
(86) Internationale Anmeldenummer: PCT/EP2003/003873
(87) Internationale Veröffentlichungsnummer: WO 2003/086958

(56) Entgegenhaltungen:
- WO-A-01/32575
- DE-A- 4 024 275
- DE-A- 4 307 869
- JP-A- 6 265 702
- US-B1- 6 221 562
- US-B1- 6 221 687
- STUDER V ET AL: "NANOEMBOSSING OF THERMOPLASTIC POLYMERS FOR MICROFLUIDIC APPLICATIONS" APPLIED PHYSICS LETTERS, AMERICAN INSTITUTE OF PHYSICS. NEW YORK, US, Bd. 80, Nr. 19, 13. Mai 2002 (2002-05-13), Seiten 3614-3616, XP001123382 ISSN: 0003-6951

## Beschreibung

Die Erfindung betrifft ein Verfahren zur Herstellung eines Erzeugnisses mit einer strukturierten Oberfläche, die aus Mikrostrukturen in Glas und glasähnlichem Material besteht. Glas wird für eine Vielzahl von Anwendungen unter anderem wegen seiner hervorragenden optischen und chemischen Eigenschaften geschätzt und verwendet. Gläser sind z.B. hochresistent gegen Wasser, Wasserdampf und insbesondere auch gegen aggressive Stoffe, wie Säuren und Basen. Ferner sind Gläser durch verschiedene Zusammensetzungen oder Zusätze außerordentlich variabel und lassen sich somit an eine Vielzahl von Anwendungsgebieten anpassen.

Ein großes Anwendungsfeld für Gläser ist die Optik und Optoelektronik. Z.B. im Bereich der Datenübertragung ist die Verwendung von optischen Bauelementen nicht mehr wegzudenken. Gerade in diesem Anwendungsfeld werden die Bauelemente immer kleiner, wodurch die Anforderungen an die Präzision der Bauelemente stetig wachsen. Z.B. besteht einer hoher Bedarf an lichtbeeinflussenden, z.B. refraktiven oder diffraktiven Bauelementen von höchster optischer Güte. An dieser Stelle seien nur beispielhaft optische Mikrolinsen genannt.

Glas eignet sich aufgrund seiner hervorragenden optischen Eigenschaften hierfür sehr gut. Im Gegenzug bereitet Glas aber einige Schwierigkeiten in der Anwendung. So ist die genaue Bearbeitung, insbesondere eine feine Strukturierung von Glas problembehaftet.

Es ist zwar bekannt Gläser nass- oder trockenchemisch zu ätzen. Jedoch lassen sich besonders bei Gläsern hier nur geringe Ätzraten erreichen, so daß auch ein solches Verfahren langsam und dementsprechend für eine Massenproduktion zu kostenintensiv ist.

Beispielsweise ist es auch bekannt, Fotostrukturierbare Gläser, wie beispielsweise FOTURAN^{®} zu verwenden. Derartige Gläser sind jedoch außerordentlich teuer.

Auch mit einem Laser lassen sich auf Gläsern genaue Strukturen herstellen, jedoch ist auch diese Technik sehr langsam und für eine Massenproduktion ebenfalls zu teuer.

Ferner sind verschiedene mechanische Bearbeitungsverfahren, z.B. Schleifen und Polieren bekannt, die aber im allgemeinen nicht die mit anderen Verfahren erreichbare Genauigkeit und Feinheit ermöglichen.

Die DE 43 07 869 A beschreibt einen Mikrostrukturkörper und ein Verfahren zur dessen Herstellung. Der mikrostrukturierte Formeinsatz wird aus einem festen Körper durch feinmechanische Präzisionsbearbeitung, additive (PVD oder CVD) oder subtraktive (anisotropes Ätzen oder Ionenätzen) Strukturierung hergestellt. Der Formeinsatz wird mit einem fließfähigen Material (u.a. Reaktionsharz oder Kunststoff) ausgefüllt und überdeckt, das durch Abkühlen verfestigt wird. Das verfestigte Material wird von dem Formeinsatz getrennt, wobei der Mikrostrukturkörper erhalten bleibt. Als geeignet sind aber auch pulverförmige Materialien (u.a. auch Glas) angegeben, welche durch Trocknen, Sintern oder Brennen verfestigt werden. Zum Herstellen des Formeinsatzes wird ein Material gewählt, das aufgrund seiner Eigenschaften für diese Strukturierungsmaßnahmen möglichst gut geeignet ist.

Das Dokument DE 40 24 275 A beschreibt ein Verfahren zur Herstellung von Mikrostrukturen mit bereichsweise unterschiedlicher Stufenhöhe, bei dem eine Schicht eines gegenüber Röntgenstrahlung empfindlichen Positiv-Resistmaterials unter Verwendung einer Maske mit Röntgenstrahlung partiell bestrahlt wird, und die bestrahlten Bereiche mit Hilfe eines Entwicklers entfernt werden.

Die Publikation Studer et al., Applied Physics Letters, Vol. 80, No. 19 (2002) 3614-3616, beschreibt ein Verfahren zur Herstellung von Mikro-Strömungselementen aus Plastik, welches auf Nano-Prägen und thermisches Bonden basiert. Unter Verwendung einer (Guss-) Form aus Silizium, welche durch Elekronenstrahl-Lithographie oder reaktives Ionenätzen hergestellt werden kann, werden die Mikro-Strömungselemente mittels Nano-Prägen von thermoplastischen Polymertabletten geformt. Durch anschließendes thermisches Bonden mit einer Plastikplatte werden die Mikro-Strömungselemente versiegelt.

Die US-B1-6 221 562 beschreibt eine Methode zur Bildumkehrung, welche hybride Fotoresist-Zwischenräume in Resist-Linien (-Pins) verwandelt für Anwendungen in "Sub-Feature-Größenordungen" (als Beispiel ist ein "Gate" genannt). Die Breite des Zwischenraums der "Sub-Feature-Größen" des hochauflösenden hybriden Fotoresists ist weitgehend unabhängig von dem lithographischen Prozess und der maskierenden Zielmarke. Dieser durch den Resist geformte Zwischenraum wird dann unter Verwendung von Spin-on-Glas (SOG) in eine Linie verwandelt. Der gesamte strukturierte hybride Fotoresist wird zuerst mit SOG beschichtet (mittels "Spin-on" oder "Plasmaaufbringung"), damit dieser die hybriden Zwischenräume ausfüllt und den Fotoresist bedeckt. Das SOG wird dann vertieft, um die Fotoresistschicht freizulegen. Das freiliegende Fotoresist wird dann entfernt. Die Linien bleiben zurück und dienen als Maske um die darunter liegende Schicht auf dem Substrat zu strukturieren.

Die Erfindung hat sich daher die Aufgabe gestellt, ein Verfahren bereit zu stellen, welches eine einfache und kostengünstige Herstellung eines Erzeugnisses mit einer strukturierten Oberfläche erlaubt.

Eine weitere Aufgabe der Erfindung ist es, ein Verfahren zur Herstellung eines Erzeugnisses mit einer strukturierten Oberfläche bereit zu stellen, welches eine präzise, exakt positionierbare und/oder vielfältige Strukturierung gestattet.

Noch eine Aufgabe der Erfindung ist es, ein Verfahren zur Herstellung eines Erzeugnisses mit einer strukturierten, insbesondere mikrostrukturierten, Oberfläche bereit zu stellen, welches sich für Glas oder ein Material mit glasartiger Struktur eignet. Noch eine weitere Aufgabe der Erfindung ist es, ein Verfahren zur Herstellung eines Erzeugnisses mit einer strukturierten Oberfläche bereit zu stellen, welches für die Massenfertigung geeignet ist und die Nachteile des Standes der Technik meidet oder zumindest mindert.

Die Aufgabe der Erfindung wird in überraschend einfacher Weise bereits durch den Gegenstand der unabhängigen Ansprüche gelöst. Vorteilhafte Weiterbildungen der Erfindung sind in den Unteransprüchen definiert.

Erfindungsgemäß nach Anspruch 1 wird ein Verfahren zur Herstellung eines Erzeugnisses mit einer vordefiniert strukturierten Oberfläche, insbesondere zur Erzeugung von Mikrostrukturen, z.B. Mikrolinsen und/oder Mikrokanälen in oder aus Glas bereitgestellt. Das Verfahren umfasst zumindest ein Bereitstellen eines Hilfssubstrats, ein Strukturieren zumindest einer Oberfläche des Hilfssubstrates und ein Aufbringen einer ersten Schicht aus einem ersten Material auf die strukturierte Oberfläche des Hilfssubstrates.

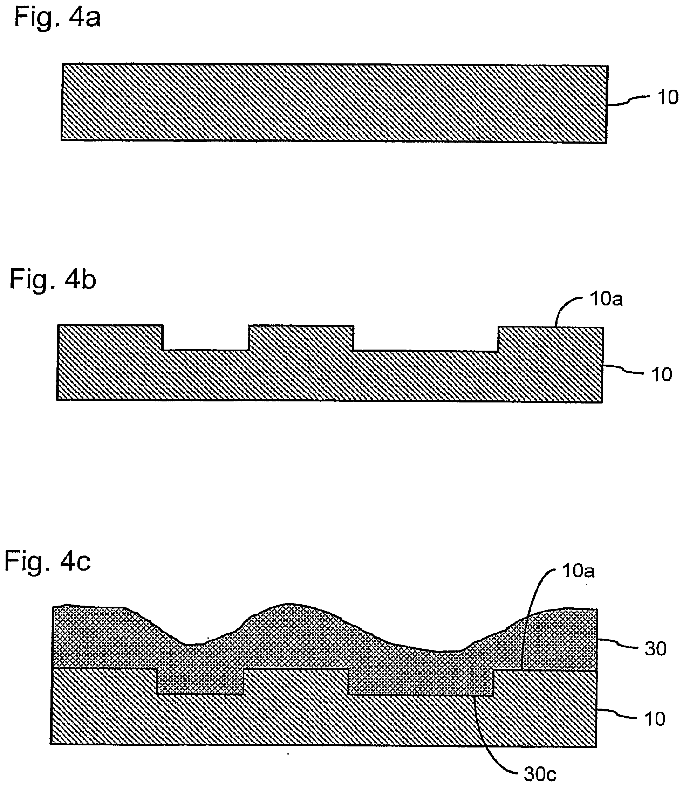

Hierbei wird im Sinne dieser Erfindung als strukturierte Oberfläche des Hilfssubstrats nicht notwendiger Weise die strukturierte unmittelbare Oberfläche des Hilfssubstrats, sondern auch die strukturierte Oberfläche einer auf dem Hilfssubstrat aufgebrachten Schicht verstanden. Nichtsdestotrotz kann das Hilfsubstrat aber auch unmittelbar strukturiert werden (vgl. Fig. 4a, 4b, 4c).

Für die Erfindung hat sich die Verwendung eines Hilfssubstrats, gegebenenfalls mit weiteren Schichten als strukturdefinierendes Element als höchst vorteilhaft erwiesen, da dessen Material anhand der Strukturierbarkeitseigenschaften ausgewählt und angepasst werden kann. Insbesondere muss das Hilfssubstrat nicht notwendig transparent sein, da es wieder entfernt wird und somit nicht Bestandteil des fertigen Erzeugnisses ist. Das entfernbare Hilfssubstrat kann ggfs. sogar wiederverwendbar sein und damit weiter zur Kostensenkung beitragen.

Demgemäß wird das Hilfssubstrat insbesondere von der ersten Schicht bzw. von dem Erzeugnis vorzugsweise nach dem Aufbringen der ersten Schicht, ggfs. nach weiteren Verfahrensschritten, wieder abgelöst oder entfernt. Mit anderen Worten ist die erste Schicht von dem Hilfssubstrat unter Erhaltung der strukturierten Oberfläche ablösbar bzw. trennbar.

Insbesondere wird also bei dem erfindungsgemäßen Verfahren eine Negativmaske oder -form mit einer vordefiniert strukturierten Oberfläche bereitgestellt und die erste Schicht auf der Negativmaske zum Erzeugen eines Positivabdruckes der strukturierten Oberfläche der Negativmaske in der ersten Schicht abgeschieden.

Bevorzugt wird auf die erste Schicht ein selbsttragender Träger oder ein Produktsubstrat aus einem dritten Material, insbesondere aus Glas, einem Material mit glasartiger Struktur oder einem anderem insbesondere transparentem Material aufgebracht.

An dieser Stelle wird deutlich, dass das erfindungsgemäße Verfahren zur Herstellung einer strukturierten Schicht auf einem Substrat, insbesondere dem Produktsubstrat einen höchst überraschenden Ansatz darstellt, da die Schicht nicht wie bei herkömmlichen Verfahren, von dem Produktsubstrat weg, sondern bezogen auf das herzustellende Erzeugnis in Richtung auf das Produktsubstrat hin aufwächst, denn mit Hilfe der Negativtechnik wächst die strukturierte Schicht auf dem Hilfssubstrat auf.

Das erfindungsgemäße Verfahren ist besonderes vorteilhaft, weil die Erzeugung von Mikrostrukturen in Glas somit einfach, schnell und kostengünstig realisierbar ist. Ferner können sehr kleine diffraktive oder refraktive Strukturen, z.B. Mikrolinsen oder Mikrokanäle in der Schichtoberfläche hergestellt werden, wobei die Oberfläche des Hilfssubstrats entsprechende Negativformen definiert. Ferner ist die Oberflächenstruktur durch die Negativtechnik präzise vorbestimmbar und kontrollierbar, so dass ein gleichbleibende Produktqualität und hohe Oberflächengüte erzielbar sind.

Bevorzugt ist das erste Material Glas oder ein glasähnliches Material, so dass eine vordefiniert strukturierte Glasschicht mit den vorstehend genannten Vorzügen herstellbar ist. Das erfindungsgemäße Bereitstellen von Mikrostrukturen, z.B. Mikrolinsen aus Glas, einem glasähnlichen oder anderem transparenten Material eröffnet im Bereich der Glasfaseroptik ein enormes Anwendungspotential.

Als glasähnliche Schicht kommt insbesondere eine SiO₂-Schicht, die mittels CVD (chemical vapor deposition) abgeschieden und z.B. mit Phosphor und/oder Bor dotiert wird in Betracht. Die Abscheidung von Phosphor und Bor erfolgt ebenfalls aus der Gasphase. Der Vorteil einer solchen Schicht ist, dass die Reflow Temperatur geringer ist als bei Glas. Als unerwarteter Zusatznutzen der Erfindung hat sich herausgestellt, dass sich ein erfindungsgemäß strukturiertes Erzeugnis hervorragend für die Verwendung in der Mikrofluidik eignet. Hierbei ist von besonderem Vorteil, dass sich die Glasschicht versehen mit Mikrokanälen durch eine hohe chemische Beständigkeit auszeichnet.

Glas zeichnet sich weiter durch eine hohe Variabilität in Bezug auf dessen thermische, mechanische und optische Eigenschaften aus.

Besonders bevorzugt wird die erste Schicht oder Glasschicht auf dem Hilfssubstrat abgeschieden, insbesondere aufgedampft. Besonders bewährt haben sich Elektronenstrahl-Aufdampfverfahren oder Sputterverfahren. Hierbei wird vorzugsweise ein Aufdampfglas, z.B. das Aufdampfglas 8329 der Fa. Schott in einer Vakuumkammer mittels eines Elektronenstrahls bis zum Verdampfen erhitzt, wobei sich der Dampf auf dem Hilfssubstrat niederschlägt und verglast.
Diesbezüglich wird auch auf die Anmeldungen
DE 202 05 830.1, eingereicht am 15.04.2002,
DE 102 22 964.3, eingereicht am 23.05.2002;
DE 102 22 609.1, eingereicht am 23.05.2002;
DE 102 22 958.9, eingereicht am 23.05.2002;
DE 102 52 787.3, eingereicht am 13.11.2002;
DE 103 01 559.0, eingereicht am 16.01.2003
desselben Anmelders verwiesen. "Folgende Prozeßparameter für das Aufbringen einer geschlossenen Glasschicht sind vorteilhaft:

| | |
|---|---|
| Oberflächenrauhigkeit des Substrats: | < 50 µm |
| BIAS-Temperatur während der Verdampfung: | ≈100°C |
| Druck während der Verdampfung: | 10⁻⁴ mbar |

Vorteilhaft wird das Abscheiden oder Aufdampfen der ersten Schicht mittels Plasma-Ionen-unterstütztem Aufdampfen (PIAD) durchgeführt. Dabei wird zusätzlich ein Ionenstrahl auf das zu beschichtende Substrat gerichtet. Der Ionenstrahl kann mittels einer Plasmaquelle, beispielsweise durch Ionisation eines geeigneten Gases erzeugt werden. Durch das Plasma erfolgt eine zusätzliche Verdichtung der Schicht sowie die Ablösung lose haftender Partikel auf der Substratoberfläche. Dies führt zu besonders dichten und defektarmen abgeschiedenen Schichten.

Gemäß einer bevorzugten Weiterbildung der Erfindung wird die erste Schicht nach dem Aufbringen bzw. Abscheiden planarisiert, z.B. chemisch und/oder mechanisch. Hierfür kommen nasschemisches Abätzen oder Schleifen und/oder Polieren der Glasschicht in Betracht. Das Produktsubstrat wird hierbei vorzugsweise nach dem Planarisieren aufgebracht.

Bevorzugt wird das, insbesondere selbsttragende und dem Erzeugnis stabilitätgebende Produktsubstrat auf der insbesondere planarisierten ersten Schicht bzw. Glasschicht aufgebracht. Dabei wird das Produktsubstrat z.B. mit der ersten Schicht anodisch gebondet. Anodisches Bonden hat den Vorteil, dass das hergestellte Erzeugnis chemisch hoch beanspruchbar ist.

Alternativ oder ergänzend wird das Produktsubstrat auf die erste Schicht aufgeklebt. Insbesondere hierbei kann das Planarisieren vorteilhafterweise entfallen, da der Kleber Unebenheiten auszugleichen vermag. In diesem Beispiel erfolgt das Planarisieren sozusagen durch den Kleber. Diese einfache Ausführungsform eignet sich besonders für nicht-optische Erzeugnisse, also z.B. Erzeugnisse für die Mikrofluidik. Als Kleber wird z.B. ein, insbesondere transparentes Epoxid verwendet.

Sowohl beim anodischen Bonden als auch beim Kleben mit Epoxid entsteht nach dem Entfernen des Hilfssubstrats als Zwischen- oder Endprodukt, herstellbar oder hergestellt mit dem erfindungsgemäßen Verfahren, ein fester und dauerhafter sandwichartiger Verbund aus dem Produktsubstrat, der ersten Schicht bzw. Glasschicht und der Verbindungsschicht, verkörpert durch das anodische Bonding oder das Epoxid.

Insbesondere sind das Produktsubstrat und/oder die erste Schicht transparent, so dass der Verbund insbesondere für Licht, vorzugsweise im sichtbaren oder infraroten Bereich, durchlässig oder transparent ist. Mit anderen Worten wird erfindungsgemäß ein optisches, z.B. refraktives oder diffraktives Verbundelement erzeugt. Somit können erfindungsgemäß z.B. ganze Mikrolinsenarrays hergestellt werden.

Alternativ oder ergänzend werden vorzugsweise weitere Schichten wie z.B. eine Antireflexschicht und/oder eine Infrarot-absorbierende Schicht, insbesondere auf der planarisierten ersten Schicht, also zwischen der ersten Schicht und dem Produktsubstrat aufgebracht. Eine solche Schicht oder Schichten können aber auch auf einer der ersten Schicht gegenüberliegenden Seite des Produktsubstrats auf dieses aufgebracht werden. Dadurch werden weitere optische Komponenten integriert.

Gemäß einer bevorzugten Ausführungsform der Erfindung umfasst das Hilfssubstrat einen selbsttragenden Träger aus einem zweitem Material oder besteht aus einem solchen. Als zweites Material wird vorzugsweise kein Glas, sondern insbesondere ein Halbleitermaterial, z.B. Silizium und/oder eine Keramik und/oder ein Metall, z.B. Aluminium und/oder eine Metalllegierung verwendet.

Gemäß einer besonderen Weiterentwicklung der Erfindung wird unmittelbar das Hilfssubstrat oder genauer in das zweite Material strukturiert, so dass nicht notwendiger Weise weitere Schichten vor dem Abscheiden der Glasschicht aufgebracht werden müssen, aber können. Insbesondere bei dieser Weiterbildung wird das Hilfssubstrat vor oder gegebenenfalls nach dem Schritt des Strukturierens, insbesondere chemisch oder mechanisch, z.B. durch Planläppen, planarisiert.

Um nach dem Abscheiden der Glasschicht die Glasstruktur freizulegen, wird vorzugsweise das Hilfssubstrat, insbesondere das zweite Material, im wesentlichen vollständig oder zumindest teilweise weggeätzt. Z.B. wird im Falle eines Silizium-Hilfssubstrats dieses chemisch mittels Kaliumhydroxid (KOH) aufgelöst.

Alternativ oder ergänzend zu der vorstehend beschriebenen Ausführungsform umfasst das Hilfssubstrat gemäß einer weiteren Ausführungsform einen selbsttragenden Träger aus einem zweiten Material und eine Strukturierungsschicht, welche auf den Träger aufgebracht wird. Bevorzugt wird hierbei die Strukturierungsschicht und nicht der Träger strukturiert.

Die Strukturierungsschicht umfasst oder besteht aus insbesondere Lack, Fotolack, Resist oder Fotoresist. Insbesondere für die Herstellung von analogen Strukturen, z.B. Linsen wird ein Grautonresist eingesetzt. Die Strukturierungsschicht wird nach dem Abscheiden der Glasschicht dann vollständig oder zumindest teilweise weggeätzt, insbesondere chemisch aufgelöst.

Gemäß einer bevorzugten Weiterbildung der Erfindung sind zwischen dem Träger und der Strukturierungsschicht noch zumindest eine oder mehrere Zwischenschichten angeordnet. Die Zwischenschicht bzw. -schichten umfassen bevorzugt einen oder bestehen aus einem Resist. Insbesondere sind das Resist der Zwischenschicht und das Resist der Strukturierungsschicht aus verschiedenen Materialien, so dass ein selektives Wegätzen ermöglicht ist.

Bei einer besonders bevorzugten Ausführungsform wird das Hilfssubstrat bzw. die Strukturierungsschicht lithografisch strukturiert. Alternativ oder ergänzend kann aber die Strukturierung auch mittels eines Präzisionsmasters mechanisch, z.B. durch Einpressen, insbesondere in eine Folie erzeugt werden. Sogar bei diesem einfachen Verfahren sind Genauigkeiten im Mikrometerbereich erreichbar.

Für Strukturen mit geringeren Genauigkeitsanforderungen kann die Strukturierung z.B. mittels Screenprinting erzeugt werden.

Besonders einfach und daher bevorzugt ist das Aufbringen oder Aufkleben einer bereits vorstrukturierten bzw. mikrostrukturierten Folie auf das Hilfssubstrat.

Die Erfindung steht ferner in Zusammenhang mit den Erfindungen, welche in der deutschen Gebrauchsmusteranmeldung U-202 05 830.1, eingereicht am 15. April 2002 und der deutschen Patentanmeldung DE-102 22 609.1, eingereicht am 23. Mai 2002 beschrieben sind.

Im Folgenden wird die Erfindung anhand von Ausführungsbeispielen und unter Bezugnahme auf die Zeichnungen näher erläutert.

### Kurzbeschreibung der Figuren

Es zeigen:
- Fig. 1a-i: die Herstellung eines erfindungsgemäßen Erzeugnisses gemäß einer ersten Ausführungsform der Erfindung,
- Fig. 2a,b: die Herstellung eines erfindungsgemäßen Erzeugnisses gemäß einer zweiten Ausführungsform der Erfindung,
- Fig. 3a-f: die Herstellung eines erfindungsgemäßen Erzeugnisses gemäß einer dritten Ausführungsform der Erfindung,
- Fig. 4a,b,c: die Herstellung eines erfindungsgemäßen Erzeugnisses gemäß einer vierten Ausführungsform der Erfindung, und
- Fig. 5a,b: die Herstellung eines erfindungsgemäßen Erzeugnisses gemäß einer fünften Ausführungsform der Erfindung,
- Fig. 6a,b,c: die Herstellung eines erfindungsgemäßen Erzeugnisses gemäß einer sechsten Ausführungsform der Erfindung,
- Fig. 7: Ergebnisse einer TOF-SIMS-Messung,
- Fig. 8: ein Foto einer Mikroskopaufnahme und
- Fig. 9: eine schematische Darstellung eines Wafers mit Lochmaske für einen Dichtigkeitstest.

### Detaillierte Beschreibung der Erfindung

Im Folgenden werden beispielhaft sechs Ausführungsformen der Erfindung vorgestellt, wobei die Merkmale der verschiedenen Ausführungsformen miteinander kombiniert werden können.

Die Zeichnungen zeigen schematische Schnittdarstellungen des Erzeugnisses in dem jeweiligen Herstellungsstadium. Der Übersichtlichkeit halber sind Figuren, in welchen gleiche oder ähnliche Herstellungsstadien dargestellt sind, mit gleichen Buchstaben bezeichnet, so dass einige Buchstaben bei der Figurennummerierung ausgelassen wurden. Gleiche und ähnliche Elemente sind in den Figuren mit gleichen Bezugszeichen versehen.

### Beispiel 1

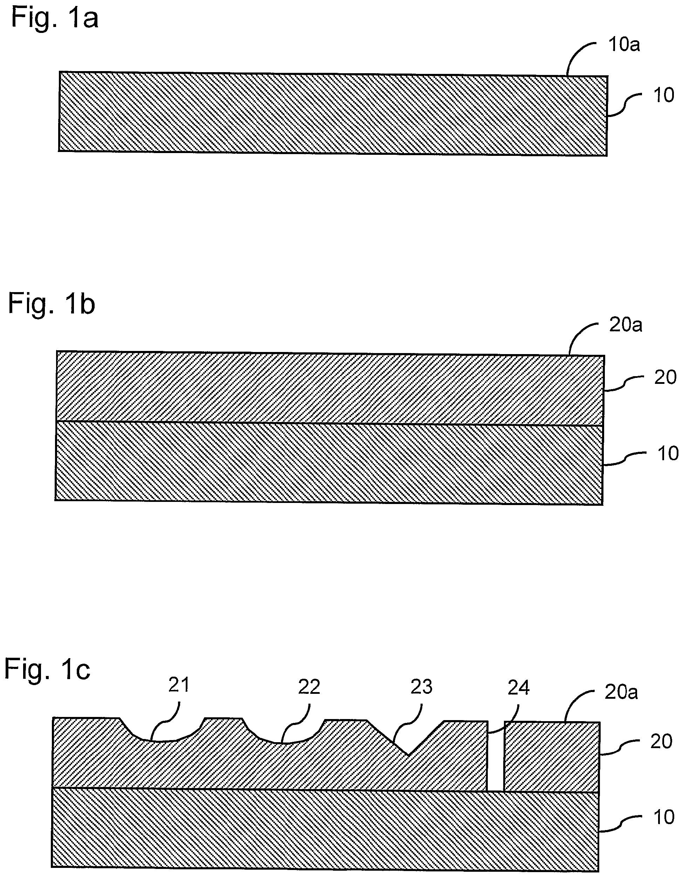

Fig. 1a zeigt ein Hilfssubstrat 10 aus Silizium.

Gemäß dem nächsten Verfahrensschritt, dargestellt in Fig. 1b, wird eine Schicht aus Fotoresist, genauer aus Grautonresist 20 auf eine Oberseite 10a des Substrats 10 aufgebracht. Das Grautonresist hat den Vorteil, dass auch analoge Strukturen erzeugt werden können.

Wie in Fig. 1c dargestellt, wird das Grautonresist 20 mittels Grautonlithografie mit Strukturen 21 bis 24 versehen. Dabei stellen die Strukturen 21 und 22 zwei rotationssymmetrische Mulden dar, die als Negativform für zwei Konvexlinsen ausgebildet sind. Die Struktur 23 bildet die Negativform für eine dreieckige Struktur und die Struktur 24 bildet die Negativform für eine rechteckige binäre diffraktive Struktur.

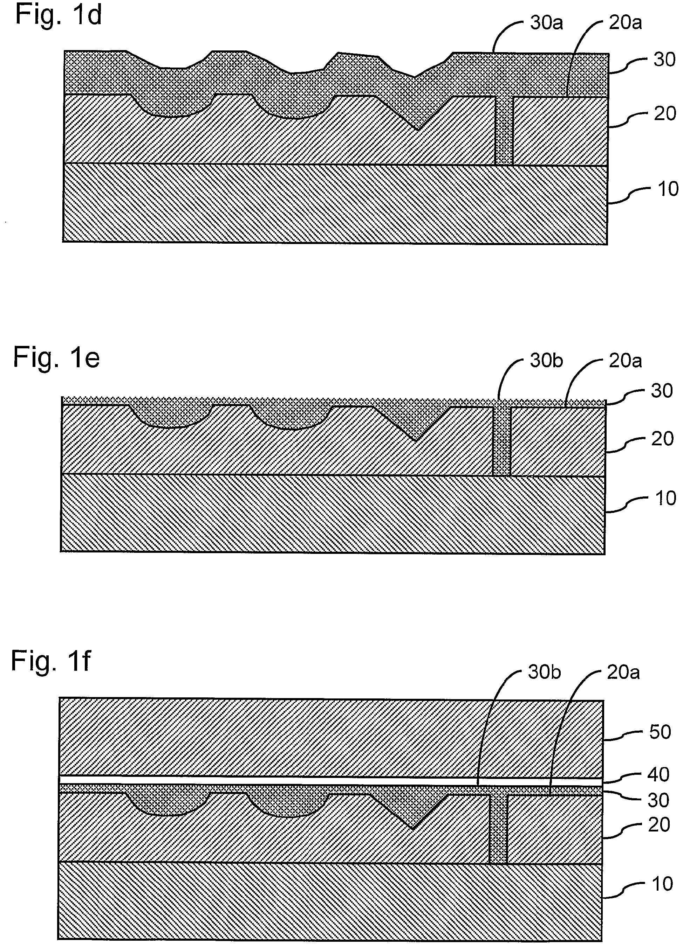

Wie in Fig. 1d dargestellt, wird auf eine Oberseite 20a des Resists 20 eine erste Schicht oder Glasschicht 30 physikalisch mittels PVD (physical vapor deposition) abgeschieden. Als Material für die Glasschicht 30 wird in diesem Beispiel das Aufdampfglas 8329 der Firma Schott Glas verwendet. Alternativ kann aber auch nahezu jedes andere aufdampffähige Glas verwendet werden. Aber auch andere Materialien als Glas, wie z.B. AL₂O₃ oder SiO₂ können abgeschieden werden.

Um die, wie in Fig. 1d zu sehen ist, unebene Oberfläche 30a der Glasschicht 30 zu glätten, wird diese planarisiert.

In dem vorliegenden Ausführungsbeispiel wird das Planarisieren durch ein Abschleifen und Polieren der Glasschicht 30 auf der dem Hilfssubstrat 10 abgewandten Seite 30a der Glasschicht 30 erzielt. Dadurch erhält die Glasschicht 30 eine glatt polierte Oberfläche 30b. Das Ergebnis nach dem Planarisieren ist in Fig. 1e dargestellt.

Wie in Fig. 1f gezeigt ist, wird ein nicht mit dem Hilfssubstrat 10 identisches Produktsubstrat 50 mit der Glasschicht 30 an deren Oberfläche 30b anodisch gebondet, wobei das Bonding in Fig. 1f mit dem Bezugszeichen 40 bezeichnet ist.

Als Produktsubstrat 50 wird z.B. ein gezogenes Glas, insbesondere D263 der Firma Schott verwendet. Je nach Anwendung kann auch ein alkalifreies Glas, z.B. AF45, AF37, der Firma Schott von Vorteil sein. Alternativ wird ein Float-Glas, z.B. Borofloat 33 der Firma Schott, bekannt unter dem Namen "Jenaer Glas" verwendet. Das Produktsubstrat 50 ist selbsttragend und dient zur Stabilisierung des herzustellenden Erzeugnisses, so dass die Glasschicht 30 in diesem Beispiel nicht selbsttragend ist, aber sein kann.

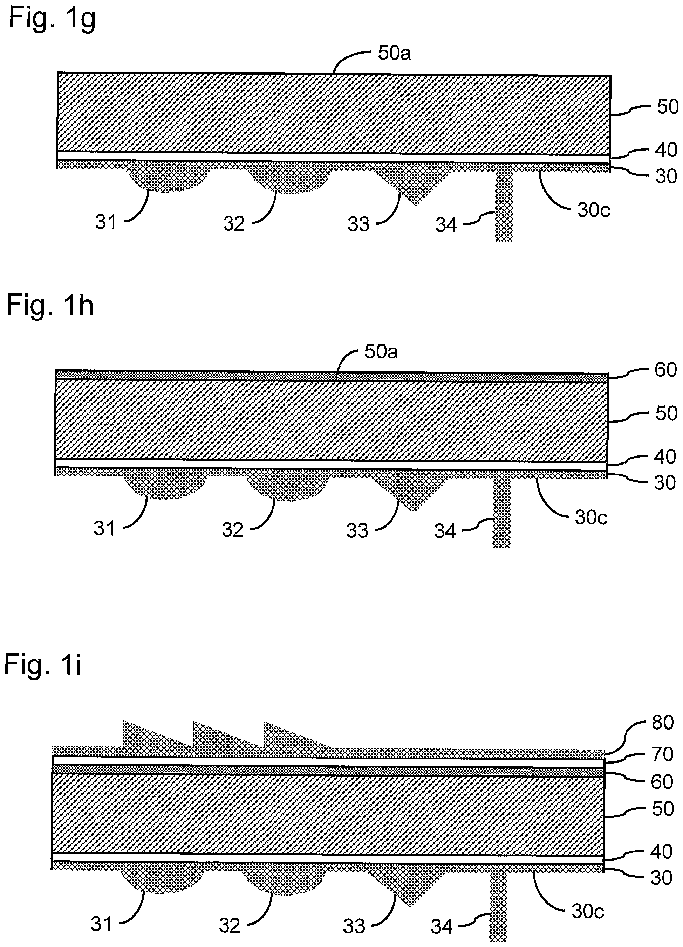

Anschließend werden das Hilfssubstrat 10 und das Grautonresist 20 durch Wegätzen des Grautonresists entfernt, so dass, wie in Fig. 1g dargestellt ist, nur noch das Produktsubstrat 50, die Glasschicht oder Glasstruktur 30 und das anodische Bonding 40 übrig sind. Die Glasschicht 30 weist Positivstrukturen 31 bis 34, welche zu den Negativstrukturen 21 bis 24 komplementär sind, auf. Die Positivstrukturen umfassen zwei rotationssymmetrische konvexe Linsen 31, 32 mit einem Durchmesser von etwa 1 mm, einen dreieckigen Vorsprung 33 und eine rechteckige Struktur 34. Die Strukturen 33 und 34 erstrecken sich senkrecht zur Bildebene. Es ist dem Fachmann ersichtlich, dass mit dem erfindungsgemäßen Verfahren aber auch nahezu jede beliebige andere binäre und nicht-binäre Struktur in der Glasschicht 30 erzeugbar ist. Insbesondere sind Strukturen kleiner als 500 µm, 200 µm, 100 µm, 50 µm, 20 µm oder 10 µm herstellbar.

Das Erzeugnis, wie es in Fig. 1g dargestellt ist, verkörpert folglich bereits ein optisch transparentes Erzeugnis mit einer mikrostrukturierten Oberfläche. Gemäß diesem Ausführungsführungsbeispiel wird das Erzeugnis jedoch gemäß Fig. 1h und 1i weiterbearbeitet, um ein Erzeugnis mit zwei oder beidseits strukturierten Oberflächen zu erhalten.

Bezug nehmend auf Fig. 1h wird eine Antireflexschicht 60 auf die der Glasschicht 30 abgewandte Oberseite 50a des Produktsubstrats 50 aufgebracht. Alternativ oder ergänzend können z.B. auch eine Infrarot-absorbierende Schicht und/oder weitere optische Schichten aufgebracht werden.

Bezug nehmend auf Fig. 1i ist dargestellt, dass eine zweite strukturierte Glasschicht mittels anodischem Bonden 70 auf die Antireflexschicht 60 aufgebracht wird. Die zweite strukturierte.Glasschicht 80 ist nach demselben Verfahren hergestellt, wie die erste strukturierte Glasschicht 30. Dabei kann es vorteilhaft sein, die zweite strukturierte Glasschicht 80 noch zusammen mit dem zugehörigen Fotoresist und Hilfssubstrat (nicht dargestellt), d.h. in einem Fig. 1e entsprechenden Stadium auf die Antireflexschicht 70 aufzubringen und erst nachfolgend das zu der zweiten Glasschicht 80 gehörige Fotoresist und Hilfssubstrat (nicht dargestellt) abzuätzen.

Alternativ kann die zweite strukturierte Glasschicht 80 auch auf das Produktsubstrat 50 aufgebracht werden, bevor das Hilfssubstrat 10 und das Fotoresist 20 von der ersten strukturierten Glasschicht 30 abgeätzt sind, d.h. in dem in Fig. 1f dargestellten Stadium, gegebenenfalls noch unter Zwischenschaltung der Antireflexschicht 60 und/oder weiterer Schichten. Diese Vorgehensweise hat den Vorteil, dass die zu der ersten und zweiten strukturierten Glasschicht 30, 80 gehörigen Fotoresists und Hilfssubstrate gleichzeitig abgeätzt werden können.

### Beispiel 2

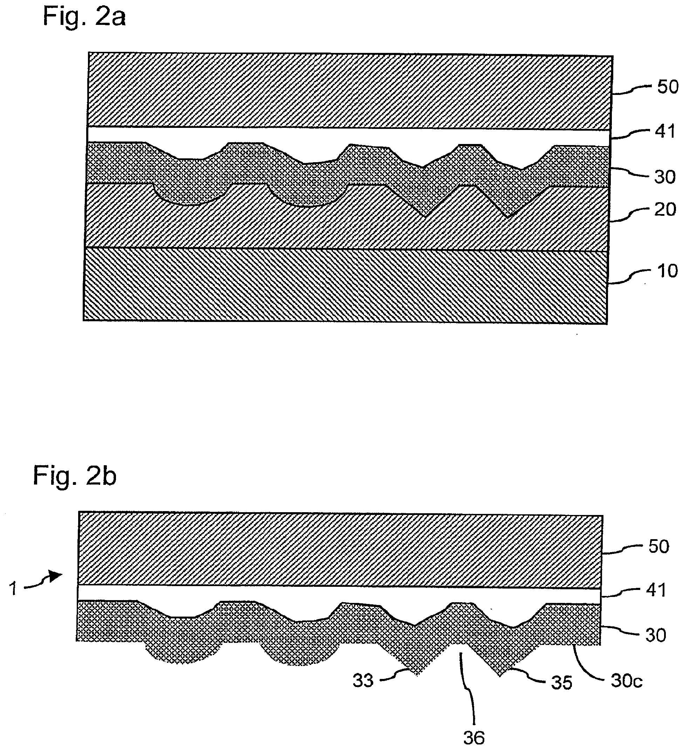

Bezug nehmend auf Fig. 2a ist ein Erzeugnis dargestellt, welches anstatt mittels anodischem Bonden mittels einer Schicht aus Epoxid 41 verklebt ist. Ansonsten ist das Erzeugnis bis zu dem in Fig. 2a darstellten Stadium entsprechend der in Fig. 1a bis 1d dargestellten Schritte hergestellt.

Als Ausgangspunkt für das Aufkleben des Produktsubstrats oder Trägers 50 dient also das Erzeugnis vor dem Schritt des Planarisierens der Glasschicht 30. Auf die unebene Glasschicht 30 wird mittels des Epoxids das Produktsubstrat 50 aufgeklebt. Wie in Fig. 2a zu sehen ist, gleicht das Epoxid 41 die Unebenheiten in der Glasschicht 30 aus.

Bezug nehmend auf Fig. 2b werden das Hilfssubstrat 10 und das Fotoresist 20 wie bei der ersten Ausführungsform weggeätzt.

Das in Fig. 2b dargestellte Erzeugnis 1 unterscheidet sich noch durch eine weitere dreieckige binäre Struktur 35, welche anstatt der binären Struktur 34 vorgesehen ist, von dem Erzeugnis in Fig. 1d. Zwischen den beiden sich senkrecht zur Bildebene erstreckenden dreieckigen Strukturen 33, 35 entsteht ein Mikrokanal 36 mit einem Fassungsvermögen im Bereich von 0,1 bis 2 µl. Das Erzeugnis 1 eignet sich dadurch hervorragend für die Mikrofluidik, z.B. für einen sogenannten DNA-Prozessor, insbesondere aufgrund der biologischen Neutralität von Glas.

Da bei dem Erzeugnis 1 gemäß der zweiten Ausführungsform der Erfindung, wie in Fig. 2b dargestellt ist, die Verbindungs- oder Klebeschicht 41 nicht beidseits plan ausgebildet ist, hat es sich als vorteilhaft erwiesen, ein Epoxid mit einem Brechungsindex, welcher ähnlich demjenigen der strukturierten Glasschicht 30 und des Produktsubstrats 50 ist, zu verwenden.

Als Epoxid 41 hat sich ein optischer Epoxidkleber, z.B. "Delo Katiobond 4653" der Firma Delo, basierend auf einem einkomponentigen, lösungsmittelfreien UV-Klebstoff mit einem Brechungsindex n = 1,5 besonders bewährt.

Im vorliegenden Fall sind die Brechungsindizes wie folgt ausgewählt:

| | | |
|---|---|---|
| Produktsubstrat 50 | Glas AF45 | n=1,52 |
| Epoxidschicht 41 | Delo Katiobond 4653 | n=1,50 |
| Glasschicht 30 | Aufdampfglas 8329 | n=1,47 |

Bei Verwendung von Borofloat 33 (n=1,47) oder D263 (n=1,52) als Material für das Produktsubstrat 50 kann aufgrund der geringen Index-Unterschiede mit demselben Epoxid gearbeitet werden. Sollen andere Gläser entweder für die Glasschicht 30 oder das Produktsubstrat 50 verwendet werden, wird ein Epoxid mit entsprechendem Brechungsindex ausgewählt. Epoxide mit Brechungsindizes von 1,3 bis 1,7 sind hierfür erhältlich.

### Beispiel 3

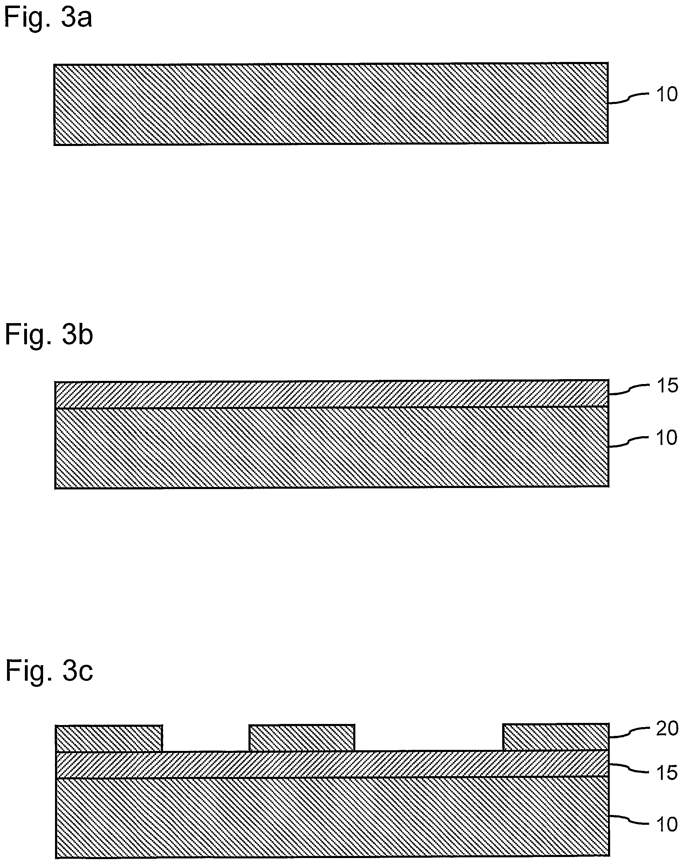

Die Figuren 3a-f zeigen die Herstellung des erfindungsgemäßen Erzeugnisses gemäß einer dritten Ausführungsform der Erfindung mit ausschließlich binären Strukturen.

Zunächst wird ein selbsttragendes Hilfssubstrat 10 aus Silzium bereitgestellt (Fig. 3a). Anschließend wird eine erste Zwischenschicht 15 auf das Hilfssubstrat 10 aufgebracht. Die Zwischenschicht 15 kann ein Fotoresist oder eine einfache nicht fotoempfindliche Zwischenschicht, z.B. aus Kunststoff sein.

Auf die Zwischenschicht 15 wird eine Fotoresistschicht 20 aufgebracht und z.B. mittels Fotolithographie binär strukturiert. Das Ergebnis ist in Fig. 3c dargestellt.

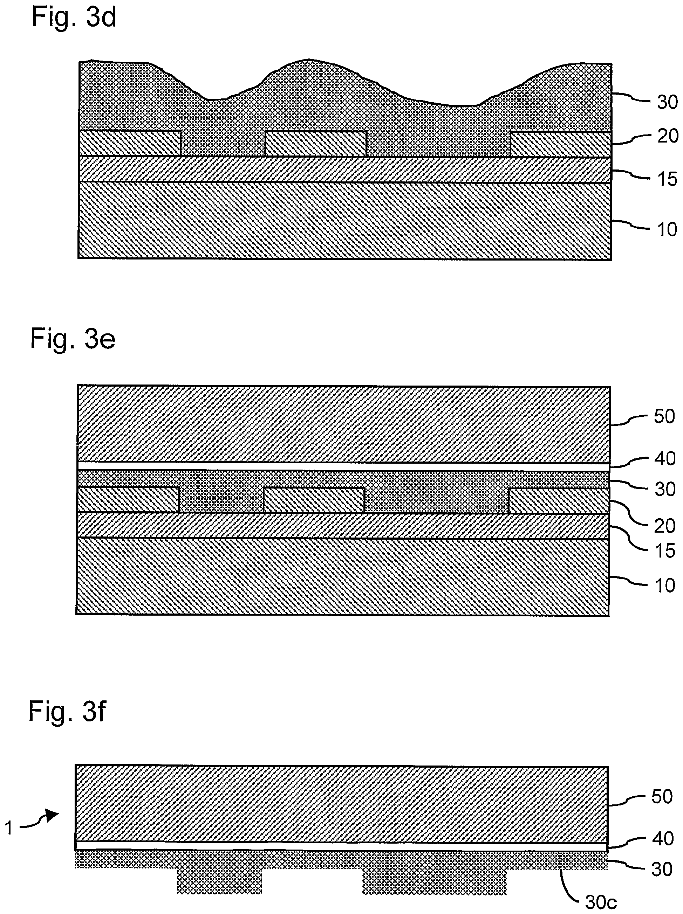

Anschließend wird eine Glasschicht 30 aufgedampft (Fig. 3d). Die Glasschicht 30 wird planarisiert und ein Produktsubstrat 50 auf die planarisierte Glasschicht 30 anodisch gebondet (Fig. 3e).

Anschließend werden das Hilfssubstrat, die Zwischenschicht 15 und die Fotoresistschicht 20 abgeätzt, so dass die strukturierte Oberfläche 30c der Glasschicht 30 freigelegt wird, und das optische Erzeugnis 1 (Fig. 3f) bereitgestellt ist.

Die Zwischenschicht 15 verhindert hierbei ein Verkleben des Aufdampfglases 30 mit dem Hilfssubstrat 10. Folglich ist die vorstehend beschriebene Ausführungsform besonders vorteilhaft für die Herstellung binärer Strukturen, für die kein Grautonresist verwendet wird.

### Beispiel 4

Bezug nehmend auf Fig. 4a wird ein Hilfssubstrat 10 zur Herstellung eines erfindungsgemäßen Erzeugnisses gemäß einer fünften Ausführungsform der Erfindung bereitgestellt. Das Hilfssubstrat 10 besteht aus einer polierten Siliziumscheibe.

Bezug nehmend auf Fig. 4b wird eine binäre Negativstruktur 10a mittels chemischem Nassätzen unmittelbar in dem Hilfssubstrat 10, d.h. in dem Silizium erzeugt.

Anschließend wird die Glasschicht 30 aufgedampft und das Erzeugnis entsprechend den anderen Ausführungsformen weiterverarbeitet.

Bei diesem Ausführungsbeispiel wird das Hilfssubstrat 10, genauer das Silizium mittels einer KOH-Lösung aufgelöst, um die strukturierte Oberfläche 30c freizulegen

### Beispiel 5

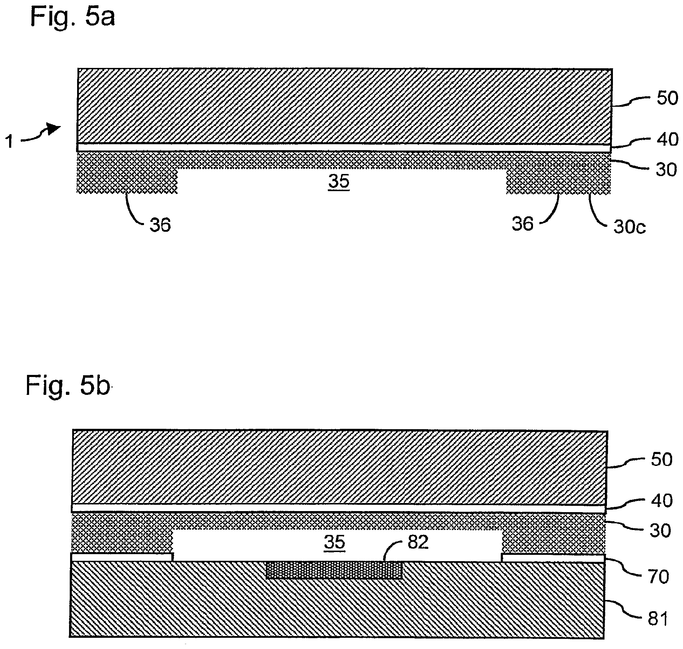

Fig. 5a zeigt ein erfindungsgemäßes Erzeugnis gemäß einer vierten Ausführungsform in einem Stadium entsprechend Fig. 3f, mit einer etwas anders strukturierten Oberfläche 30c. Die Oberfläche 30c der Glasschicht 30 weist eine zentrale Vertiefung 35 und erhabene Vorsprünge 36 am äußeren Rand auf.

Bezug nehmend auf Fig. 5b wird das Erzeugnis 1 mit den Unterseiten der Vorsprünge 36 der Glasschicht 30 mittels einem zweiten anodischem Bonding 70 mit einem zweiten Produktsubstrat 81 verbunden. Dabei entsteht ein zentraler Hohlraum 35 um eine MEMS-Struktur (mikro-elektro-mechanisches System) 82, welche mit diesem Verfahren gekapselt wird.

### Beispiel 6

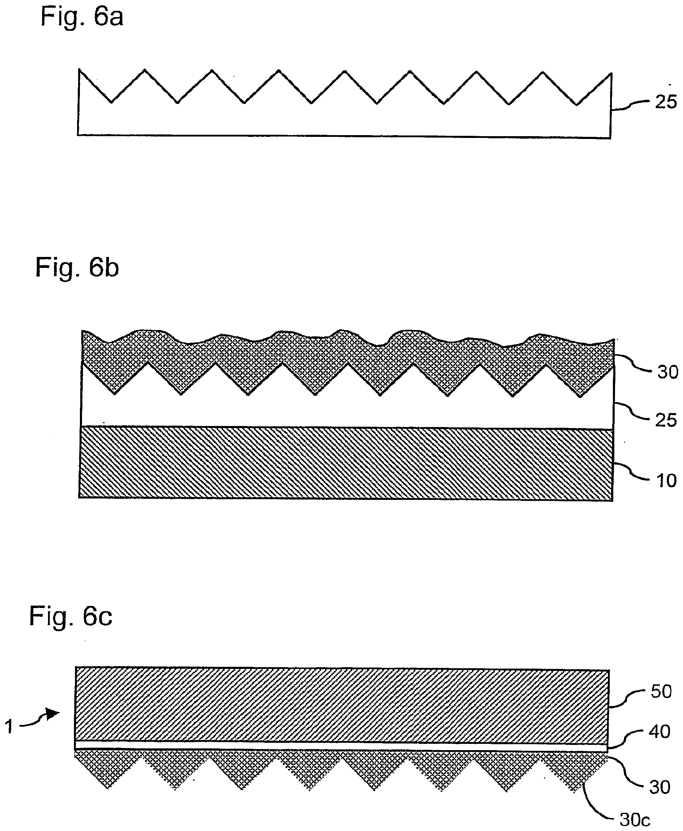

Fig. 6a zeigt eine geprägte, vorstrukturierte Kunststofffolie 25 wie sie z.B. als Meterware von der Firma 3M erhältlich ist.

Die vorstrukturierte Folie 25 wird auf das Hilfssubstrat 10 aufgebracht, z.B. aufgeklebt (Fig. 6b). Anschließend wird die Glasschicht 30 auf die strukturierte Oberfläche der Kunststofffolie 25 aufgedampft.

Bezug nehmend auf Fig. 6c wird die Glasschicht 30 abgeschliffen und mit dem Produktsubstrat 50 anodisch gebondet. Anschließend werden das Hilfssubstrat 10 und die Kunststofffolie 25 z.B. durch Ätzen oder anderweitiges Ablösen entfernt. Es entsteht wiederum ein vollständig transparentes Erzeugnis 1 mit einer einseitig strukturierten Oberfläche in Form der strukturierten Glasschicht 30 auf dem Glasträger 50.
Im Folgenden sind Ergebnisse verschiedener Untersuchungen von aufgedampften Glasschichten aus dem Glas 8329 dargestellt.

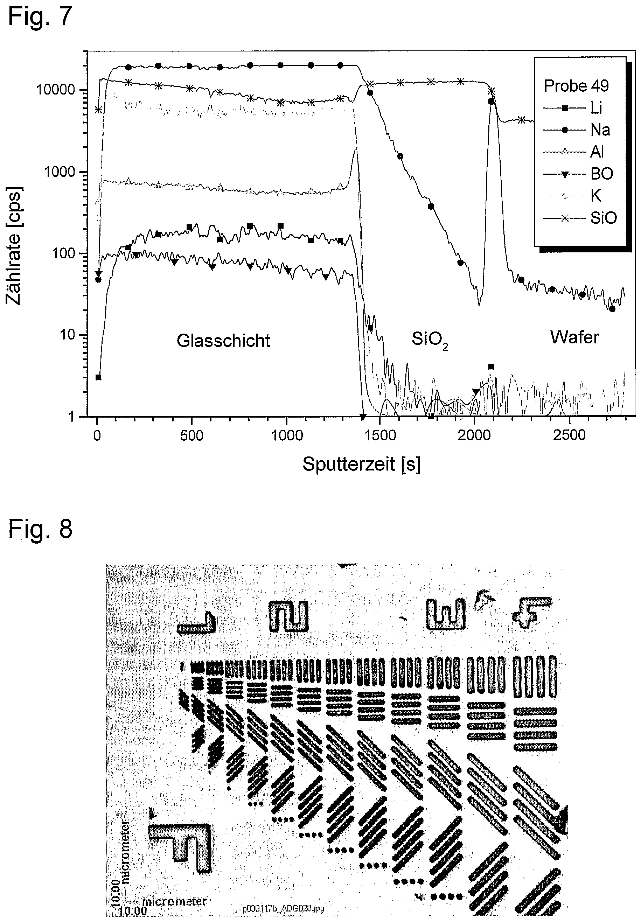

Bezugnehmend auf Fig. 7 sind die Ergebnisse einer TOF-SIMS-Messung gezeigt, wobei die Zählrate als Funktion der Sputterzeit aufgetragen ist. Die Messung charakterisiert den Verlauf der Elementkonzentrationen der Glasschicht. Es wurde eine Dickenkonstanz für die Glasschicht von < 1% der Schichtdicke ermittelt.

Bezugnehmend auf Fig. 8 sind erfindungsgemäß erzeugte Glasstrukturen des Glases 8329 dargestellt.

Darüber hinaus wurden Dichtigkeitstests der Kopierschutzschicht aus dem Glas 8329 wie folgt durchgeführt.

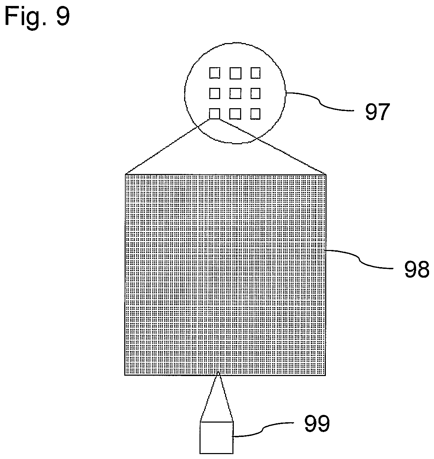

Es wurde ein Silizium-Wafer mit einer Ätzstopmaske versehen. Wie in Fig. 9 dargestellt ist, wurde der Wafer 97 in neun Lochareale 98 (1 cm x 1 cm) untergliedert. Der Einzellochabstand in den Arealen wurde von Reihe zu Reihe wie folgt verändert.
1. Reihe: 1mm Lochabstand
2. Reihe: 0,5mm Lochabstand
3. Reihe: 0,2mm Lochabstand
Alle quadratischen Löcher 99 besitzen eine Kantenlänge von 15 µm.

Nach Beschichten der nicht strukturierten Waferrückseite mit einer 8µm (Probe A) bzw. 18µm (Probe B) Schicht aus dem Glas 8329, wurde anschließend der Wafer in den Lochflächen bis zum Glas trockengeätzt. Der Erfolg des Ätzens konnte gut im Durchlichtmikroskop beobachtet werden.

Ein Helium Lecktest ergab bei allen 18 gemessenen Arealen eine Leckrate von kleiner als 10⁻⁸ mbar 1/sec.

Erstaunlich ist auch die hohe Festigkeit der Glasschichtbereiche trotz erheblicher Durchwölbung des Wafers während der Messung im jeweiligen Messareal. Auch nach einer Temperung bei 200°C stellte sich keine Veränderung der Glasstruktur ein.

Ferner wurden Beständigkeitsmessungen der Glasschicht nach DIN/ISO durchgeführt. Die Ergebnisse sind in Tabelle 1 wiedergegeben.

**Tabelle 1:**

| Probenbezeichnung: | **8329** | | |
|---|---|---|---|
| **Wasser DIN ISO 719** | Verbrauch HCl [ml/g] | Äquivalent Na₂O [µg/g] | Bemerkungen |
| Klasse | | | |
| **HGB1** | **0,011** | **3** | **keine** |

| **Säure DIN 12116** | Abtrag [mg/dm²] | Gesamt-Oberfläche [cm²] | Bemerkungen/ sichtbare Veränderungen |
|---|---|---|---|
| Klasse | | | |
| **1 W** | **0,4** | **2 x 40** | **unverändert** |
| **Als Werkstoff** | | | |

| **Lauge DIN ISO 695** | Abtrag [mg/dm²] | Gesamt-Oberfläche | Bemerkungen/ sichtbare Veränderungen |
|---|---|---|---|
| Klasse | | [cm²] | |
| **A 2** | **122** | **2x14** | **unverändert** |
| **Als Werkstoff** | | | |

## Patentansprüche

1. Verfahren zur Herstellung eines Erzeugnisses (1) mit einer strukturierten Oberfläche (30c) mit diffraktiven oder refraktiven Strukturen, umfassend zumindest die Schritte:
Bereitstellen eines Hilfssubstrats (10, 20) mit einer strukturierten Oberfläche (20a),
wobei die strukturierte Oberfläche (20a) des Hilfssubstrats (10,20) entsprechende Negativformen definiert und
Aufbringen einer ersten Schicht (30) aus einem ersten Material auf die strukturierte Oberfläche (20a) des Hilfssubstrats (10, 20), wobei das erste Material (30) Glas oder ein glasähnliches Material umfasst und das erste Material (30) gesputtert oder verdampft wird, um auf der strukturierten Oberfläche (20a) des Hilfssubstrats (10, 20) abgeschieden zu werden, und wobei die erste Schicht (30) mittels Plasma-Ionen-unterstütztem Aufdampfen abgeschieden wird, sowie Entfernen des Hilfssubstrates (10, 20).

2. Verfahren nach vorstehendem Anspruch,
**dadurch gekennzeichnet, dass** die strukturierte Oberfläche (20a) des Hilfssubstrats (10, 20) eine Negativform (21, 22, 23, 24) für optische Linsen oder Kanäle definiert.

3. Verfahren nach einem der vorstehenden Ansprüche,
**dadurch gekennzeichnet, dass**
die erste Schicht (30) planarisiert (30b) wird.

4. Verfahren nach einem der vorstehenden Ansprüche,
**dadurch gekennzeichnet, dass**
ein Produktsubstrat (50) aufgebracht wird.

5. Verfahren nach einem der vorstehenden Ansprüche,
**dadurch gekennzeichnet, dass**
ein Produktsubstrat (50) umfassend Glas oder ein glasähnliches Material aufgebracht wird.

6. Verfahren nach einem der vorstehenden Ansprüche,
**dadurch gekennzeichnet, dass**
ein Produktsubstrat (50) auf die erste Schicht (30) aufgeklebt (41) wird.

7. Verfahren nach einem der vorstehenden Ansprüche,
**dadurch gekennzeichnet, dass**
ein Produktsubstrat (50) mit der ersten Schicht (30) anodisch gebondet (40) wird.

8. Verfahren nach einem der vorstehenden Ansprüche,
**dadurch gekennzeichnet, dass**
das Hilfssubstrat einen selbsttragenden Träger (10) aus einem zweitem Material umfasst und unmittelbar das zweite Material strukturiert wird.

9. Verfahren nach einem der vorstehenden Ansprüche,
**dadurch gekennzeichnet, dass** das Hilfssubstrat (10) vor dem Schritt des Strukturierens planarisiert wird.

10. Verfahren nach einem der vorstehenden Ansprüche,
**dadurch gekennzeichnet, dass**
das Hilfssubstrat (10, 20) zumindest teilweise weggeätzt wird.

11. Verfahren nach einem der vorstehenden Ansprüche,
**dadurch gekennzeichnet, dass**
das Hilfssubstrat einen Träger (10) aus einem zweiten Material umfasst,
eine Strukturierungsschicht (20) auf den Träger aufgebracht wird und
die Strukturierungsschicht strukturiert wird.

12. Verfahren nach Anspruch 11,
**dadurch gekennzeichnet, dass**
die Strukturierungsschicht (20) eine vorstrukturierte Folie (25) umfasst.

13. Verfahren nach Anspruch 11 oder 12,
**dadurch gekennzeichnet, dass**
zwischen den Träger (10) und die Strukturierungsschicht (20) eine Zwischenschicht (15) aufgebracht wird.

14. Verfahren nach einem der vorstehenden Ansprüche,
**dadurch gekennzeichnet, dass**
eine Strukturierungsschicht (20) umfassend ein Fotoresist oder Grautonresist aufgebracht wird.

15. Verfahren nach einem der vorstehenden Ansprüche,
**dadurch gekennzeichnet, dass**
der Schritt des Strukturierens ein lithografisches Verfahren oder ein mechanisches Pressen umfasst.

## Claims

1. A method for producing a product (1) having a structured surface (30c) with diffractive or refractive structures, comprising at least the steps of:
providing an auxiliary substrate (10, 20) that has a structured surface (20a),
wherein the structured surface (20a) of the auxiliary substrate (10, 20) defines respective negative moulding shapes; and
applying a first layer (30) of a first material onto the structured surface (20a) of the auxiliary substrate (10, 20),
wherein the first material (30) comprises glass or a glass-like material and the first material (30) is sputtered or vapourized to be deposited on the structured surface (20a) of the auxiliary substrate (10, 20), and wherein the first layer (30) is deposited by plasma ion assisted vapour deposition; and
removing the auxiliary substrate (10, 20).

2. The method according to the preceding claim,
**characterized in that** the structured surface (20a) of the auxiliary substrate (10, 20) defines a negative moulding shape (21, 22, 23, 24) for optical lenses or for channels.

3. The method according to any one of the preceding claims,
**characterized in that**
the first layer (30) is planarized (30b).

4. The method according to any one of the preceding claims,
**characterized in that**
a product substrate (50) is applied.

5. The method according to any one of the preceding claims,
**characterized in that**
a product substrate (50) comprising glass or a glass-like material is applied.

6. The method according to any one of the preceding claims,
**characterized in that**
a product substrate (50) is adhesively joined (41) to the first layer (30).

7. The method according to any one of the preceding claims,
**characterized in that**
a product substrate (50) is anodically bonded (40) to the first layer (30).

8. The method according to any one of the preceding claims,
**characterized in that**
the auxiliary substrate comprises a self-supporting carrier (10) made of a second material; and that the second material is directly structured.

9. The method according to any one of the preceding claims,
**characterized in that**
the auxiliary substrate (10) is planarized prior to the structuring step.

10. The method according to any one of the preceding claims,
**characterized in that**
the auxiliary substrate (10, 20) is at least partially etched away.

11. The method according to any one of the preceding claims,
**characterized in that**
the auxiliary substrate comprises a carrier (10) made of a second material;
a structuring layer (20) is applied onto the carrier; and
the structuring layer is structured.

12. The method according to claim 11,
**characterized in that**
the structuring layer (20) comprises a pre-structured film (25).

13. The method according to claim 11 or 12,
**characterized in that**
an intermediate layer (15) is applied between the carrier (10) and the structuring layer (20).

14. The method according to any one of the preceding claims,
**characterized in that**
a structuring layer (20) comprising a photoresist or grey scale resist is applied.

15. The method according to any one of the preceding claims,
**characterized in that**
the structuring step comprises a lithographic process or a mechanical pressing operation.

## Revendications

1. Procédé de fabrication d'un article (1) à surface structurée (30c) présentant des structures diffractives ou réfractives, comportant au moins les étapes consistant à :
fournir un substrat auxiliaire (10, 20) à surface structurée (20a),
les surfaces structurées (20a) du substrat auxiliaire (10, 20) définissant des empreintes négatives correspondantes, et
appliquer une première couche (30) faite d'un premier matériau sur la surface structurée (20a) du substrat auxiliaire (10, 20), le premier matériau (30) comprenant du verre ou un matériau analogue au verre et le premier matériau (30) étant soumis à une pulvérisation cathodique ou à une vaporisation, afin d'être déposé sur la surface structurée (20a) du substrat auxiliaire (10, 20), et la première couche (30) étant déposée par métallisation assistée par ions plasma, et retirer le substrat auxiliaire (10, 20).

2. Procédé selon l'une quelconque des revendications précédentes, **caractérisé en ce que** la surface structurée (20a) du substrat auxiliaire (10, 20) définit une empreinte négative (21, 22, 23, 24) pour des lentilles optiques ou des canaux.

3. Procédé selon l'une quelconque des revendications précédentes, **caractérisé en ce que** la première couche (30) est aplanie (30b).

4. Procédé selon l'une quelconque des revendications précédentes, **caractérisé en ce que** un substrat de produit (50) est appliqué.

5. Procédé selon l'une quelconque des revendications précédentes, **caractérisé en ce qu'**un substrat de produit (50) comprenant du verre ou un matériau analogue au verre est appliqué.

6. Procédé selon l'une quelconque des revendications précédentes, **caractérisé en ce qu'**un substrat de produit (50) est collé (41) sur la première couche (30).

7. Procédé selon l'une quelconque des revendications précédentes, **caractérisé en ce qu'**un substrat de produit (50) est lié anodiquement (40) à la première couche (30).

8. Procédé selon l'une quelconque des revendications précédentes, **caractérisé en ce que** le substrat auxiliaire comporte un support (10) autoporteur fait d'un deuxième matériau et le deuxième matériau est immédiatement structuré.

9. Procédé selon l'une quelconque des revendications précédentes, **caractérisé en ce que** le substrat auxiliaire (10) est aplani avant l'étape de structuration.

10. Procédé selon l'une quelconque des revendications précédentes, **caractérisé en ce que** le substrat auxiliaire (10, 20) est au moins en partie éliminé par gravure.

11. Procédé selon l'une quelconque des revendications précédentes, **caractérisé en ce que** :
le substrat auxiliaire comporte un support (10) fait d'un deuxième matériau,
une couche de structuration (20) est appliquée sur le support, et
la couche de structuration est structurée.

12. Procédé selon la revendication 11, **caractérisé en ce que** la couche de structuration (20) est un film pré-structuré (25).

13. Procédé selon la revendication 11 ou 12, **caractérisé en ce qu'**une couche intermédiaire (15) est appliquée entre le support (10) et la couche de structuration (20).

14. Procédé selon l'une quelconque des revendications précédentes, **caractérisé en ce qu'**une couche de structuration (20) comprenant un photoresist ou une réserve de valeur de gris (« Grautonresist ») est appliquée.

15. Procédé selon l'une quelconque des revendications précédentes, **caractérisé en ce que** l'étape de structuration comprend un procédé lithographique ou un pressage mécanique.
